# EUROPEAN PATENT APPLICATION

(11) **EP 4 715 400 A1**
(43) Date of publication of application: **25.03.2026**
(21) Application number: 25203755.1
(22) Date of filing: 22.09.2025
(51) Int. Cl.: G01R 21/133, G01R 22/06

(54) **METROLOGY AND APPLICATION PROCESSORS**

(30) Priority: 24.09.2024 US 202463698364 P
(71) Applicant: Analog Devices International Unlimited Company, Co. Limerick (IE)
(72) Inventor: O'Keeffe, Dermot G., Limerick (IE); Hurwitz, Jonathan Ephraim David, Limerick (IE)
(74) Representative: Horler, Philip John

(57) **Abstract**

A utility meter is provided. The utility meter comprises a metrology processor and an application processor. The metrology processor is configured to receive input current and voltage measurements from one or more sensors. The application processor is configured to receive the energy consumption data from the metrology processor and output the energy consumption data. Primary and secondary communication links are provided between the metrology processor and the application processor and configured to transmit the energy consumption data from the metrology processor to the application processor.

## Description

### Technical Field

The present disclosure relates to a utility meter comprising a metrology and application processor and the transmission of data between the processors.

### Background

Electric utility meters measure the electricity usage of a property, such a residential or industrial property. Load current and voltages may be measured, then used to compute the energy consumption (often in kW-hours). The load current may be measured using a current transducer, such as a shunt resistor, Hall effect sensor, current transformer, or current measurement coil. The voltage across the load may be measured using any suitable voltage measurement technique.

Providing accurate energy consumption measurements allows utility companies to accurately bill for consumed energy. Utility meters can also help in monitoring and managing the usage of utilities, detecting leaks or faults, and improving energy efficiency.

A meter may be tampered with to reduce the apparent energy consumption of a property, in an attempt to steal electricity. This may involve slowing the apparent rate at which the meter measures energy consumption or stopping measurement all together. There is a need to ensure that meters provide accurate measurements, even in the event of attempted tampering.

### Summary

According to a first aspect of the present disclosure, there is provided a utility meter comprising: a metrology processor configured to receive input current and voltage measurements from one or more sensors and determine an energy consumption based on the measurements; an application processor configured to receive the energy consumption data from the metrology processor and output the energy consumption data; a primary communication link between the metrology processor and the application processor configured to transmit the energy consumption data from the metrology processor to the application processor; a secondary communication link between the metrology processor and the application processor configured to transmit the energy consumption data from the metrology processor to the application processor.

According to a second aspect of the present disclosure, there is provided a method of controlling a utility meter comprising a metrology processor and an application processor, the method comprising: receiving input current and voltage measurements from one or more sensors at the metrology processor; determining, using the metrology processor, an energy consumption based on the measurements; transmitting energy consumption data from the metrology processor to the application processor using a primary communication link; transmitting the energy consumption data from the metrology processor to the application processor using a secondary communication link; outputting the energy consumption data using the application processor.

According to a third aspect of the present disclosure, there is provided a utility meter comprising: a metrology processor configured to receive input current and voltage measurements from one or more sensors and determine an energy consumption based on the measurements; an application processor configured to receive the energy consumption data from the metrology processor; a primary communication link between the metrology processor and the application processor configured to transmit the energy consumption data between the processors; an optical communication link between the metrology processor and the application processor configured to transmit the energy consumption data between the processors.

### Drawings

Aspects of the disclosure are described, by way of example only, with reference to drawings in which:
Figure 1a is a schematic diagram of a utility meter;
Figure 1b is a simplified schematic diagram of the utility meter of Figure 1a;
Figure 2 is a schematic diagram of a utility meter comprising separate metrology and application processors;
Figure 3 is a schematic diagram of a utility meter comprising two communication links;
Figure 4 is a schematic diagram of a utility meter comprising an optical communication link;
Figure 5 is a schematic diagram of a utility meter comprising an optical communication link with a filter or light pipe;
Figure 6 is a schematic diagram of a utility meter comprising three communication links;
Figure 7 is a flow chart of a method of communicating data between a metrology and application processor;
Figure 8 is a diagram of a processor.

### Detailed Description

A utility meter is provided having a metrology processor and an application processor. The metrology processor may be any suitable processor configured to receive input current and voltage measurements and determine an energy consumption or power usage based on the input current and voltage measurements. The metrology processor provides the energy consumption data to the application processor. The application processor may be any suitable processor configured to receive the energy consumption or power usage data and output that data. The application processor may output the energy consumption data to any suitable external system, such as a display that may be read by a user or employee of an electric utility company. The application processor may additionally or alternatively output the energy consumption data to an external system, such as a server provided by an electric utility company. This allows accurate records of energy consumption to be provided, allowing accurate billing. The application processor may process the data in any suitable manner such that it can be provided to the one or more outputs.

The metrology processor and application processor may be provided in separate locations. For example, the metrology processor may be positioned or provided adjacent to one or more current and voltage measurement devices or sensors. The current and voltage measurement sensors may be coupled to conductors that supply power to a commercial or residential property. The application processor may be provided adjacent to one or more displays or output means (such as a transmitter, antenna or transceiver). Providing the processors adjacent to their respective outputs and inputs reduces the distance between the processors and their respective outputs and inputs, reducing the impact of external noise sources or interference. However, it results in a need to transmit the energy consumption data over a greater distance between the metrology processor and the application processor.

A primary communication link is provided between the metrology processor and the application processor. The metrology processor is configured to transmit the energy consumption data over the primary communication link. A secondary communication link is provided between the metrology processor and the application processor. The metrology processor is also configured to transmit the energy consumption data over the secondary communication link.

Some users or third parties may attempt to reduce the apparent rate that the utility meter records energy consumption or stop the recording of energy consumption altogether by tampering with the utility meter. This may occur through attempted tampering with the communication links between the processors, for example using electromagnetic interference. Transmitting the same energy consumption data over a primary and secondary link provides redundancy, such that even if one of the communication links is tampered with, the application processor still receives the energy consumption data from the other.

Providing the same data over the two (or more) communication links allows the application processor to compare the energy consumption data for correspondence and determine whether a fault is present or if tampering has occurred. For example, if a user attempts to tamper with the communication links, it is unlikely that they would be able to tamper with both in exactly the same manner. As such, the tampering may cause a discrepancy between the energy consumption data transmitted over the two communication links. If the application processor determines that a discrepancy or difference is present, it may determine that tampering has occurred.

Where tampering has occurred, the application processor may continue to output the energy consumption to the display so that the user is not aware that the tampering has been detected. The application processor may further output a report that a fault or tampering has occurred to an external system such as a server which records energy consumption data. This allows the utility meter to accurately measure and output energy consumption.

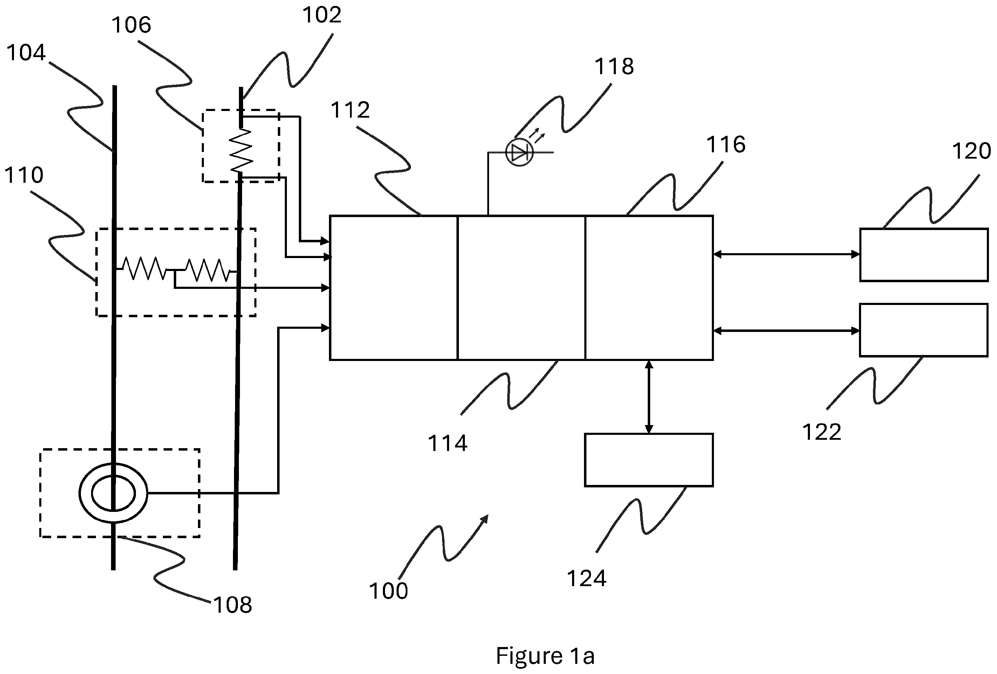

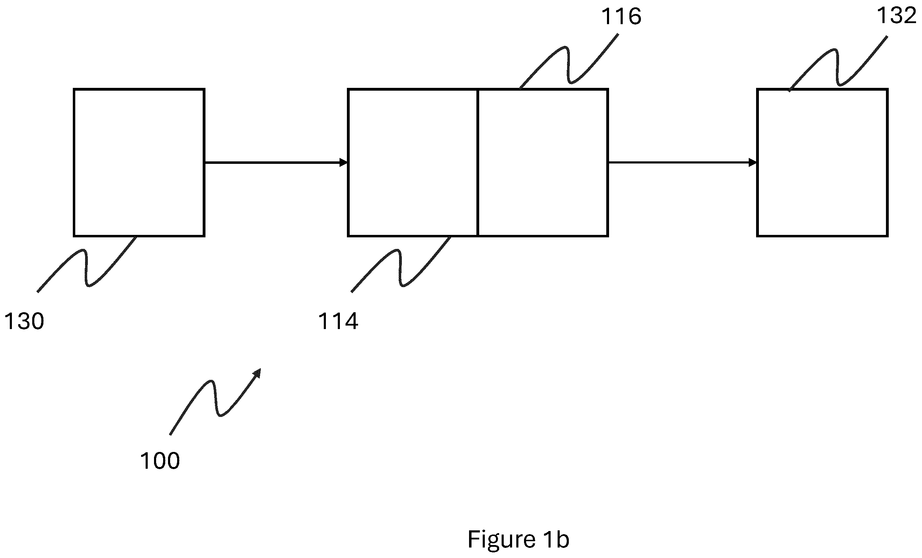

Figure 1a shows a utility meter 100. The utility meter 100 is arranged to measure the current and voltage passing through conductors. The utility meter 100 shown in Figure 1 is a single-phase meter, however it should be understood that the following techniques and systems may also be applied to a split-phase or multi-phase (such as three-phase) utility meters. Figure 1a shows a first conductor or line 102 and a second conductor or line 104. The first conductor 102 is a live conductor and the second conductor 104 is a neutral conductor.

The utility meter 100 is configured to measure the current in the live conductor 102 using a first current sensor 106. The first current sensor 106 is depicted as a current shunt (a resistor in the path of the current, with the voltage across the resistor being proportional to the current) however any suitable current sensor may be used. The utility meter 100 is further configured to measure the current in the neutral conductor 104 using a second current sensor 108. The second current sensor 108 is depicted as a Rogowski coil, current measurement coil or differential current sensor, however any suitable current sensor may be used. The utility meter is further configured to measure the voltage between the first conductor 102 and second conductor 104 using a voltage sensor 110. The voltage sensor 110 is depicted as a potential divider coupled between the conductors or lines, however any suitable voltage sensor may be used.

Whilst three sensors are shown in Figure 1, it should be understood that one or more sensors may be provided. For example, a single current measurement sensor and a single voltage measurement sensor may be provided, as this would allow the metrology processor to determine an energy consumption or power consumption. Further, the sensors may be of the same type or different sensor types. So as to determine energy consumption, both voltage and current may be measured. Further, whilst the conductors 102, 104 show a single-phase system, it should be understood that this disclosure may apply to a three-phase system, where there are three or four conductors and more than two voltage and current sensors.

The utility meter 100 comprises an analog front end 112 configured to receive the measured signals from the current and voltage sensors. The analog front end 112 may comprise any of buffers, integrators (to integrate a differential received current), amplifiers, level shifters, offset circuits and analog-to-digital converters (ADCs) configured to convert the received analog signals to digital signals that may be processed by further components or systems of the utility meter 100. The analog front end 112 may be an optional device, as the metrology processor 114 may directly receive analog signals or the current and voltage sensors may output digital signals directly to the metrology processor 114.

The output of the analog front end is provided to a metrology processor or microcontroller (MCU) 114. The analog front end may provide the measures of current and voltage to the metrology processor 114. Based on the received input signals, the metrology processor 114 is configured to determine the energy consumption of a load connected to the conductors 102 and 104. The load may represent single load or the combined loads of a residential or commercial property. The skilled person would understand how to compute energy consumption or power usage based on these measurements and as such it will not be discussed further here.

The metrology processor 114 may output the determined energy consumption to an application processor 116. The application processor 116 may form part of the same processor as the metrology processor 114 or be a separate processor. The application processor 116 is configured to output energy consumption readings or other data to a display 120 (of any suitable display technology) and, via a network interface controller 122 or other suitable interface, communicate the energy consumption readings to external or remote systems, such as the servers or systems of a utility company.

The application processor 116 may further store energy consumption readings locally in EEPROM 124 or any other suitable form of memory or storage.

The application processor 116 therefore provides two output means for energy consumption readings - a local display 120 and a means 122 to communicate the readings to a remote server or system. This allows local readings of energy consumption to be viewed using the display as well as transmission of the energy consumption data to a utility company for automated readings. However, it should be understood that the application processor 116 may provide the energy consumption data to any of a plurality of output devices.

The metrology processor 114 may be further connected to a light source or LED 118 and configured to pulse or control the light source operation in relation (for example proportionally) to the energy consumption. Pulsing or controlling the light source may comprise turning the light source 118 off and on at a certain frequency, pulse width or duty cycle. For example, the pulse rate or frequency of the light source may be proportional to the kWh of electricity consumption. The light source 118 may be referred to as an optical energy accumulator output or CF output. This provides a further output means, allowing a technician to verify that the light source 118, display 120 and communication means 122 are increasing or pulsing at the same rate.

Figure 1b is a simplified version of the system of Figure 1A, showing the metrology processor 114, application processor 116, one or more input means 130 and one or more output means 132. The one or more input means 130 may comprise one or more voltage and current sensors and the one or more output means 132 may comprise a display and/ or a transceiver or communications link to one or more external systems. As noted previously, the type of current or voltage sensors 130 and the type of output means 132 do not modify the functioning of the metrology processor 114 and the application processor 116, so are shown as black boxes in Figure 1b.

Electromagnetic interference (EMI) may be present in the meter environment due to either natural EMI in the environment, or an attempt at tampering with the meter by introducing an EMI source. The utility meter 100 of Figure 1a and 1b presents a number of electromagnetic interference challenges because the metrology and application processors are provided in one compact package.

Whilst a utility meter may be a relatively compact device, the outputs and inputs are typically separated from one another and susceptible to outside interference (whether background interference or interference caused by attempted tampering). Lengthy conductors between the different components may pick up this interference. As such, it is desirable for the processors to be close to both the input voltage and current sensors and the output means (such as the display 120 or transceiver 122). The processors of the utility meter 100 can be placed close to the voltage 110 and current 106, 108 sensors, however this typically increases the distance from the application processor to the display 120. Long signal routes to the display 120 can be disturbed by EMI event.

Alternatively, the processors of the utility meter 100 may be placed close to the display 120, however this typically increases the distance from the metrology processor to the voltage 110 and current 106, 108 sensors. Long signal routes to the sensors can be disturbed by an EMI event, reducing the signal to noise ratio and potentially making the signal unrecoverable or too noisy.

An EMI event may cause the energy consumption readings or current and voltage readings to be corrupted, reducing accuracy of energy consumption readings. EMI events can be used to interrupt or disable the accumulation of energy and make it appear as if nothing has been consumed or the meter has stopped functioning. This may occur due to attempted tampering with the meter.

Making a meter 100 more immune to EMI events is desirable without significant extra financial cost or circuit complexity. Further, it's advantageous to make the meter 100 appear to work correctly even if the meter reading has been corrupted, to discourage tampering.

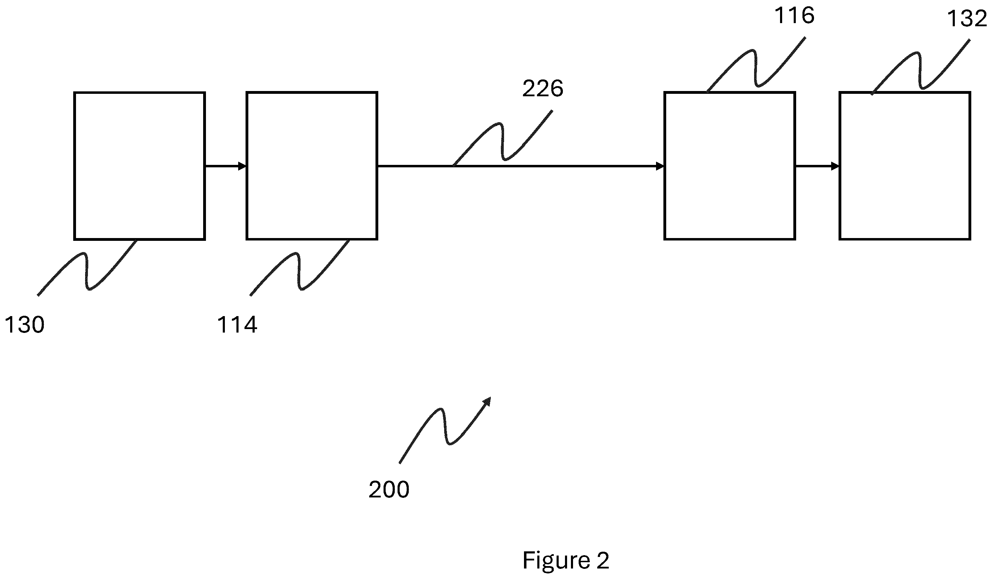

Figure 2 shows a utility meter 200. The utility meter 200 has a number of components or systems corresponding to those of Figure 1. The utility meter 200 of Figure 2 shows a simplified black box model similar to Figure 1b, however it should be understood that the detail of each component discussed with respect to Figure 1a may also apply to the utility meter 200. As such, the description of repeated components will not be included here in the interests of brevity. The utility meter 200 of Figure 2 separates the metrology processor 114 from the application processor 116. As such, the processors are different components and physically separated from one another. The metrology processor 114 is connected to the application processor 116 using a communications link 226, which is configured to transmit data, such as energy consumption data from the metrology processor 114 to the application processor 116.

Separating the metrology processor 114 and application processor 116 allows them to be located closer to the current 106, 108 and voltage sensors 110 and output display 120 respectively. There is a desire to provide a dis-aggregated utility meter in which the metrology processing and application processing are co-located near to their respective inputs or outputs.

The metrology processor 114 is co-located with the input sensors 130 comprising one or more voltage and current sensors. As such, short connections, such as PCB routes or traces are required between the metrology processor 114 and the sensors 130. This minimises the EMI risk and improves the signal to noise ratio of the signals received at the metrology processor 114.

The application processor 116 is co-located with the output means 132, such as a display or transmitter. As such, a short connection, such as PCB routes or traces are required between the application processor 116 and the output means 132.

The metrology processor 114 contains all the processing requirements to comply with the legal requirements of accurate metrology, including energy consumption calculation. The part of the utility meter 200 not contained in the metrology processor 114 is control over outputting to output means 132 such as a display or transmitter (for example formatting and modifying the received energy consumption data) and the time stamping of energy consumption, which occurs at the application processor 116.

Co-locating the metrology processor 114 with the sensors and the application processor 116 with the display reduces the EMI risks, reducing possible tampering opportunities. However, the electrical interface or communication link 226 between the metrology processor 114 and the application processor 116 may be susceptible to EMI interference due to the length of the connection between the processors. As such, an improved system with reduced susceptibility to tampering is required.

Colocation of the processors with their respective inputs or output may mean that the metrology processor 114 is closer to the input sensors 130 than it is to the application processor 116. The application processor 116 may be closer to the one or more outputs 132 than it is to the metrology processor 114.

Where a communication link is referred to throughout this disclosure, it should be understood that this may refer to either or both of the technology that provides the link between the processors (such as a fiber or air) and to the protocol or means of communication that the processors employ to transmit data (such as radio frequency, digital or optical communications) as well as a coding scheme used to transmit the data.

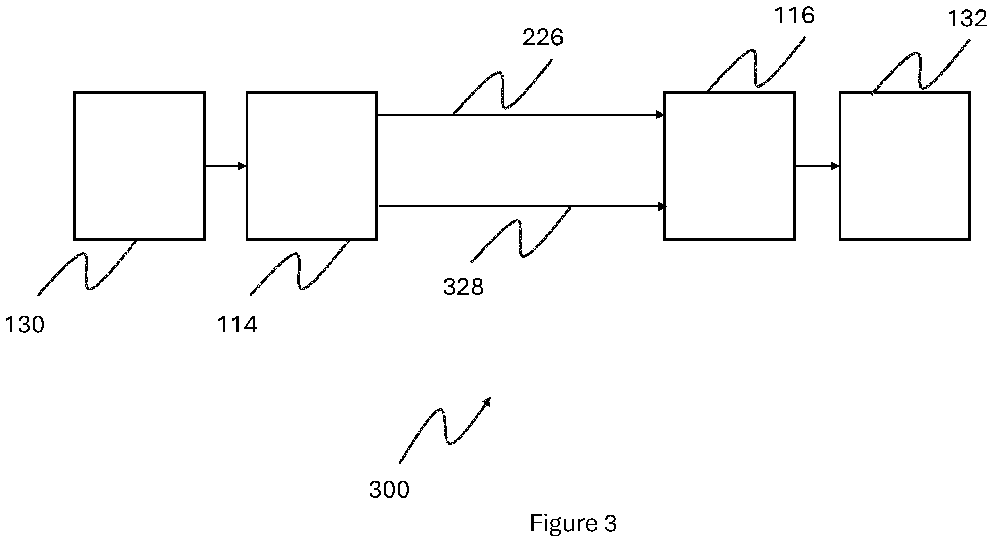

Figure 3 is a diagram of a utility meter 300 with improved EMI resistance. As with the meter shown in Figure 2, improved EMI resistance is provided by co-locating the metrology processor 114 adjacent to the sensor systems 106-110 and co-locating the application processor 116 adjacent to the display 120 output.

So as to reduce the EMI risks presented by the communication link between the metrology processor 114 and the application processor 116, two or more communication means or links are provided between the processors. A primary or first communication link 226 and a secondary or second communication link 328 are provided. The metrology processor 114 is configured to transmit, using the primary communication link 226, the energy consumption data to the application processor 116. The metrology processor 114 is configured to transmit, using the secondary communication link 328, the energy consumption data from the metrology processor 114 to the application processor 116. The energy consumption data transmitted using both communications links may be the same data however it may be encoded in different manners and/or transmitted at the same or different times.

Providing two communication links provides a level of redundancy. If one of the communication means is interfered with due to an attempted meter tampering, the remaining communication means may be unaffected. Further, if both communication links are tampered with but in different ways, the application processor 116 may determine that each of the communication links provides a different energy measurement data, indicating that tampering or a fault has occurred.

This allows the system to continue accurately recording and relaying energy consumption data, even if the primary connection or communication link 226 between the metrology processor 114 and application processor 116 is disturbed by an EMI event. This ensures that the energy consumption displayed on the display 120 is accurate.

The primary communication link 226 and the secondary communication link 328 may operate or be used in the same manner. For example, the primary communication link 226 and the secondary communication link 328 may comprise the same communication technology (such as the same medium for communication) or the metrology processor 114 may use the same communication scheme (such as RF, digital, optical) to transmit data on the communication links. Alternatively, the primary 226 and secondary 328 communication links may be different communication technologies or use different communication schemes.

The primary communication link 226 and the secondary communication link 328 may be any suitable communication link between the metrology processor 114 and the application processor 116. For example, the primary communication link 226 and/or the secondary communication link 328 may be a digital interface between the metrology processor 114 and application processor 116. The digital interface may comprise SPI, UART, I2C or any other suitable interface. Other communication links, types or technologies may be provided as the primary communication link 226 or the secondary communication link 328. The primary communication 226 and/or the secondary communication link 328 may be a radio frequency communication link using a pulse-encoding scheme where the data is encoded in the frequency or pulse-width of the transmitted signal.

The primary communication link 226 may be a unidirectional communication link capable of communicating data in single direction from the metrology processor 114 to the application processor 116. The primary communication 226 link may be a bidirectional communication link capable of transmitting data from the metrology processor 114 to the application processor 116 and from application processor 116 to the metrology processor 114. For example, the application processor 116 may request information or data relating to energy consumption from the metrology processor 114 using the primary communication link 226 and the metrology processor may transmit the energy consumption data using the primary communication link 226 to the application processor 116. The primary communication link 226 may comprise a hard-wired connection between the processors, such as a conductor between the processors.

The primary communication link 226 may be a register-based communication link with energy consumption data stored in a memory or register of or coupled to the metrology processor 114. The application processor 116 is configured to request energy consumption data from the metrology processor 114 using the primary communication link 226 and, in response to the request, the metrology processor 114 is configured to transmit the energy consumption data from a register to the application processor 116 using the primary communication link 226.

Data transmitted using the primary communication link 226 may be encoded. In the event of attempted meter tampering, for example triggering an EMC event local to the meter, the encoding may allow the attempted tampering to be detected. Further, in some cases, the data may be corrected using the coding scheme.

For example, the transmitted data may be encoded using an error correction code (ECC). The data may be encoded using a cyclic redundancy check (CRC).

It may not be possible to correct the data using the encoding scheme, however the coding scheme may be used as part of a decision by the application processor 116 as to whether the data transmitted using the primary communication link 226 is valid. The application processor 116 may, based on the received code, determine whether the data is valid or invalid. If the data is determined to be valid, the application processor 116 may use that data further, for example by displaying it on display 120. If the data is determined to be invalid, the application processor may not use data transmitted using the primary communication link 226. Instead, data transmitted using an alternative communication link, such as a secondary or optical communication link, may be used by the application processor 116.

The secondary communication link 328 may transmit the same energy consumption data as the primary communication link 226. The secondary communication 226 link may be a bidirectional or unidirectional communication link.

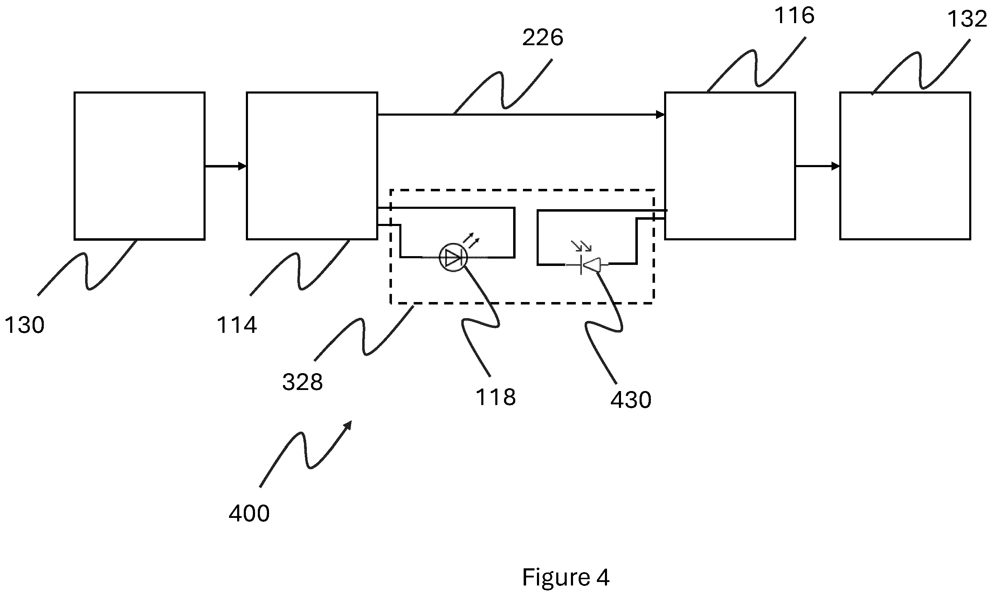

The secondary communication link 328 may be an optical communication link. Figure 4 shows a utility meter 400 with an optical communication link 328. The optical communication link 328 comprises a light source 118 coupled to and controlled by the metrology processor 114 and a photodetector 430 coupled to the application processor 116. The metrology processor 114 is configured to transmit energy consumption data using the light source 118 and the application processor 116 is configured to determine the energy consumption based on one or more optical signals received at the photodetector 430 from the light source 118. The optical communication link 328 may be a pulse-based communication link, wherein the energy consumption data is encoded in a frequency or pulse-width of an optical signal transmitted over the optical communication link. The light source 118 may be a dedicated light source provided for the purpose of transmitting energy consumption data using the optical communication link 328 to the application processor 116.

The photodetector 430, may be a photodiode, light-dependent resistor, phototransistor or any other means capable of receiving optical communications. The photodetector 330 may be positioned in the utility meter such that it is capable of receiving light transmitted by the light source 118.

The application processor 116 may be configured to receive the detected optical signal from the photodetector 430 and determine an energy consumption measured by the metrology processor 114. The application processor 116 may determine the energy consumption by monitoring or measuring the frequency of the detected optical signal (such as the frequency of an edge of the optical signal), the time between each pulse of the optical signal or the duty cycle of the optical signal or any other suitable property of the optical signal. The application processor 116 may therefore determine the energy consumption from the optical signal transmitted by the light source 118 and provide the energy consumption to one or more of the output means 132.

As noted previously, the metrology processor 114 of a utility meter may be coupled or connected to a light source or LED 118, and configured to pulse or control the light source proportionally to the energy consumption. For example, the pulse rate or pulse width of the light source may be proportional to the kWh of electricity consumption. The light source 118 may be referred to as an optical energy accumulator output or CF output. This light source 118 is used to provide a visual indication that the meter is measuring the usage of electricity, allowing a technician to determine whether the utility meter is operating to measure electricity.

As the light source 118 operates in a frequency of pulse width proportional to the energy consumption measured by the metrology processor 114 and sensors 106-110, it may be used as both the visual indicator (CF source) an optical communication means between the metrology processor 114 and application processor 116 with only limited further components. As such, the light source 118 of the optical communication link 328 may have a dual purpose - to provide a visual indication and to transmit energy consumption data to the application processor.

Providing an optical communications link that makes use of the light source 118 present in many utility meters requires limited further components (a photodetector 430) whilst significantly improving the robustness and reliability of the communication link. As such, the application processor 116 can receive information relating to energy consumption even if the primary communications link 226 is interfered with or corrupted. This allows the metrology processor and application processor to be provided in different locations (reducing the effect of EMI on the links between sensors 106-110 and the metrology processor 114, and the effect of EMI on the link between the application processor 116 and the outputs 120, 122) whilst ensuring that the link between the processors is robust.

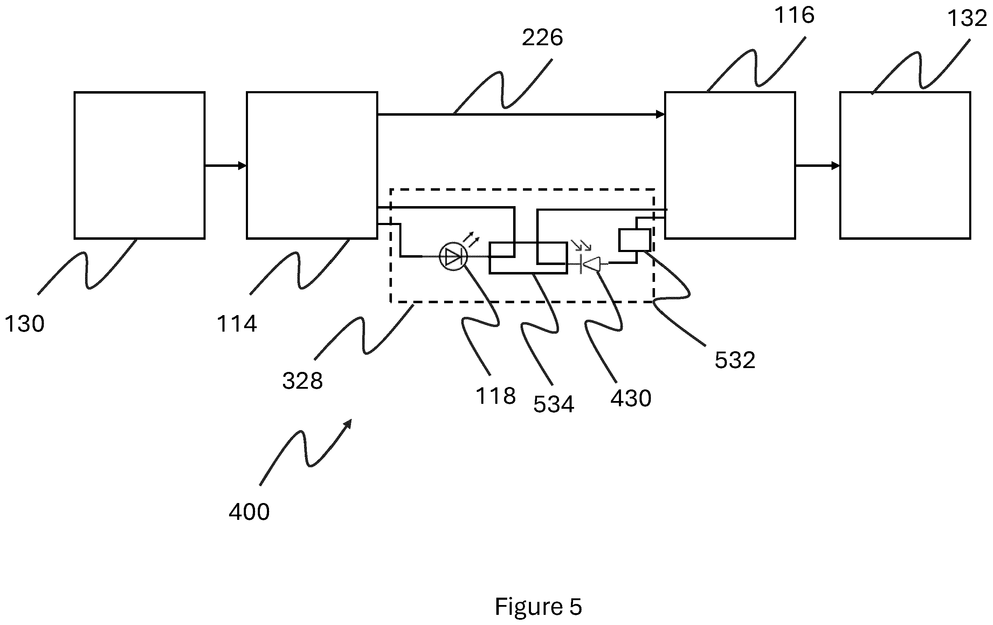

Figure 5 shows a utility meter 400 including a primary communications link 226 and an optical communications link. To reduce the possible effects of tampering, the photodetector 440 may be coupled to the application processor 116 through a filter 532. The filter 432 may be a narrowband band-pass filter with a pass-band centred on a frequency range in which the light source 118 transmits light when indicating energy consumption is taking place. This reduces the opportunity for optical tampering of the optical communications path between the metrology processor and application processor.

The utility meter 400 may, in addition or as an alternative to the filter 532, comprise a light pipe 534, optical channel or optical fibre between the light source 118 and the photo detector 430, such that light between the processors travels only within the light pipe 534. This further reduces the opportunity for tampering with the optical communications link by providing optical transmission internal to the system rather than externally.

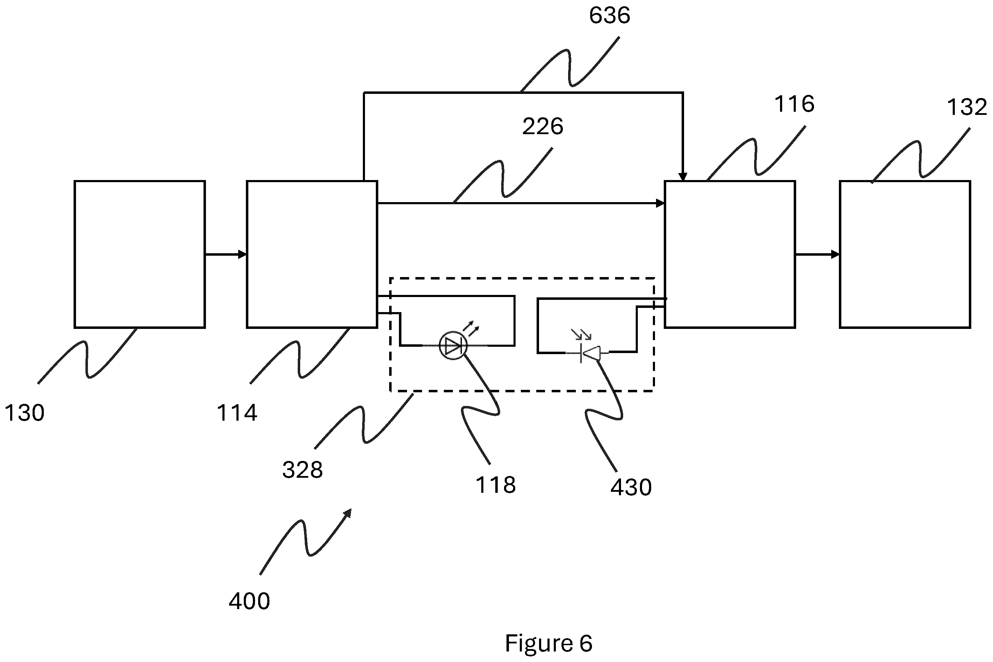

In addition to the primary 226 and secondary 328 communication links, the utility meter may comprise one or more further communication links. For example. For example, Figure 6 shows a third communications link 636 between the metrology processor 114 and the application processor 116, wherein the third communication link is configured to transmit the energy consumption data from the metrology processor 114 to the application processor 116.

The energy consumption data transmitted by the primary communications link 226, secondary communications link 328 and optionally the third communications link 636 (where present) may be compared. The application processor 116 may determine if there is a difference between the provided energy consumption data from each of the communications links to determine whether tampering has occurred on one or more of the links.

The application processor 116 is configured to compare the energy consumption data received from the primary communication link 226 and the secondary communication link 328.

If the energy consumption data received from the primary communication link 226 and the secondary communication link 328 are different, the application processor 116 may be configured to determine that there is a fault and output a fault notification to the output means 132. This fault notification may cause a fault to be displayed on a display of the output means 132. Alternatively, the fault notification may be transmitted using a transceiver or transmitter of the output means 132 to an external server system, such as the server system of a utility company. This may indicate to the utility company that the energy consumption readings are unreliable.

Determining whether there is a difference between the energy consumption data may comprise determining whether the energy consumption data received from the different communications links significantly differ or are substantially different, for example are more than 1%, 5%, 10% or 20% different. This may indicate that one or more of the communications links have been tampered with.

Further, if the application processor stops receiving energy consumption data from one of the primary communication link 226 or the secondary communication link 328, the application processor 116 may be configured to determine that there is a fault and output a fault notification to the output means 132. Stopping receiving energy consumption data from one link may indicate that an attempted tampering has taken place (for example using an RF signal that disrupts and RF communication link but does not disrupt an optical communication link). The energy consumption data received from one of the communications links may still be output to the display of the output means 132, with a fault notification output in the background. This provides a tampering alert to the utility company without notifying the user or person attempting to tamper with the utility meter that the utility meter is aware of tampering.

If a fault or tampering is determined to be present, and one or more of the communications links is a bidirectional communication link, the application processor may use the bidirectional communication link (either or both of the primary communication link 226 and secondary communication link 328) to interrogate one or more registers of the metrology processor 114 that store energy consumption data. This allows the processors to check the transmitted data against previously stored data.

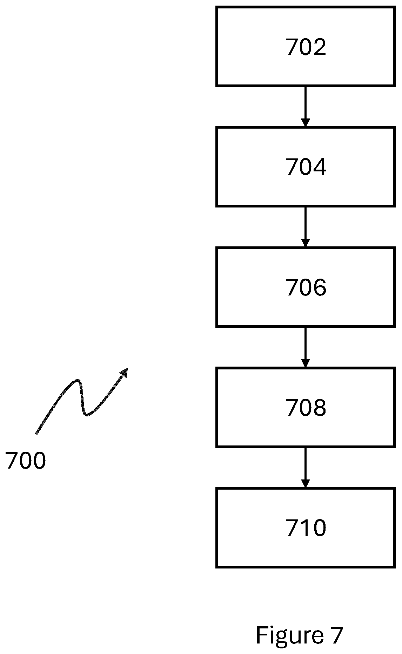

Figure 7 is a method 700 of controlling a utility meter comprising a metrology processor 114 and an application processor 116. In step 702, the method comprises receiving input current and voltage measurements from one or more sensors 130 at the metrology processor 114. In step 704, the method comprises determining, using the metrology processor 114, an energy consumption based on the measurements. In step 706 the method comprises transmitting energy consumption data from the metrology processor 114 to the application processor 116 using a primary communication link 226. In step 708 the method comprises transmitting the energy consumption data from the metrology processor 114 to the application processor 116 using a secondary communication link 328. In step 710 the method comprises outputting the energy consumption data using the application processor 116

Each of the metrology processor 114 and the application processor 116 may comprise one or more processing cores and a memory.

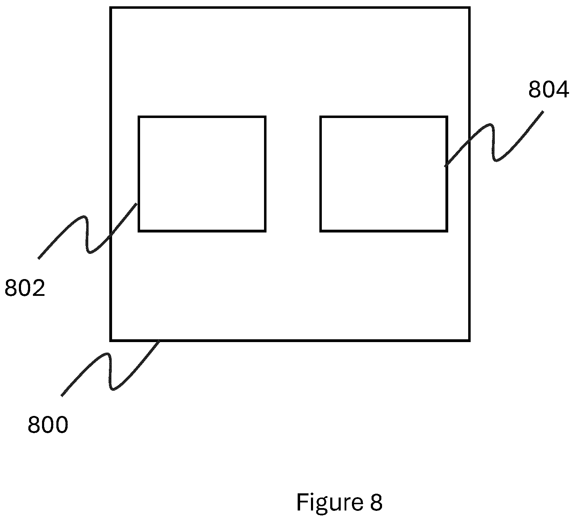

Figure 8 shows an example processor 800 that may be used in place of the metrology processor 114 and/or the application processor 116. The processor 800 comprises a processing core 802 and a memory 804. The processor 800 can be configured to perform any of the operations disclosed herein such as, for example, any of the operations discussed with reference to the functional units described in relation to the metrology processor 114 or the application processor 116 or the steps discussed with reference to figure 7.

One or more processing cores 802 can be any general purpose processor(s) configured to execute a set of instructions. For example, one or more processing cores 802 can be one or more general-purpose processors, one or more field programmable gate array (FPGA), and/or one or more application specific integrated circuits (ASIC). In one embodiment, one or more processing cores 802 include one processor. Alternatively, one or more processing cores 802 include a plurality of processors that are operatively connected.

Processing core 802 is communicatively coupled to memory 804. Memory 804 can be a random access memory (RAM), a read only memory (ROM), a persistent storage device such as a hard drive, an erasable programmable read only memory (EPROM), and/or the like.

Memory 804 can store information that can be accessed by processing core 802. For instance, memory 804 (e.g., one or more non-transitory computer-readable storage mediums, memory devices) can include computer-readable instructions (not shown) that can be executed by the processing core 802. The computer-readable instructions can be software written in any suitable programming language or can be implemented in hardware. Additionally, or alternatively, the computer-readable instructions can be executed in logically and/or virtually separate threads on processing core 802. For example, memory 804 can store instructions (not shown) that when executed by the processing core 802 cause processing core 802 to perform operations such as any of the operations and functions for which the utility meter is configured, as described herein. In addition, or alternatively, memory 804 can store data (not shown) that can be obtained, received, accessed, written, manipulated, created, and/or stored.

Various modifications whether by way of addition, deletion, or substitution of features may be made to the above described examples to provide further examples, any and all of which are intended to be encompassed by the appended aspects.

### Aspects

A first set of non-limiting aspects of the disclosure are set out in the following numbered clauses.
1. A utility meter comprising:
   a metrology processor configured to receive input current and voltage measurements from one or more sensors and determine an energy consumption based on the measurements;
   an application processor configured to receive the energy consumption data from the metrology processor and output the readings;
   a primary communication link between the metrology processor and the application processor configured to transmit the energy consumption data between the processors;
   an optical communication link between the metrology processor and the application processor configured to transmit the energy consumption data between the processors.
2. The utility meter of aspect 1, wherein the optical communication link comprises a light source coupled to and controlled by the metrology processor and a photodetector coupled to the application processor, wherein the application processor is configured to determine the energy consumption based on the optical signals received at the photodetector.
3. The utility meter of aspect 2, wherein the metrology processor is further configured to control a frequency or pulse rate of the light source in proportion to the determined energy consumption.
4. The utility meter of aspect 3, wherein the application processor is configured to determine the energy consumption based on a frequency or pulse rate of the optical signal received at the photodetector.
5. The utility meter of any of aspects 2-4, further comprising a filter coupled to the photodetector, wherein the filter is a narrowband band-pass filter with a pass-band centred on a frequency range in which the light source transmits light when indicating energy consumption.
6. The utility meter of any of aspects 2-5, further comprising a light pipe or optical channel between the light source and the photodetector, the light pipe or optical channel configured to provide internal optical transmission.
7. The utility meter of any preceding aspect, further comprising a secondary communication link between the metrology processor and the application processor, wherein the secondary communication link transmits the same energy consumption data as the primary communication link.
8. The utility meter of aspect 7, wherein the secondary communication link comprises a different communication technology than the primary communication link.
9. The utility meter of any preceding aspect, wherein the application processor is configured to compare the energy consumption data received from the primary communication link and the optical communication link.
10. The utility meter of any preceding aspect, wherein the metrology processor and the application processor are physically separated and connected via the primary communication link and the optical communication link.
11.The utility meter of any preceding aspect, further comprising one or more voltage sensors and current sensors coupled to the metrology processor and configured to provide input current and voltage measurements.
12. The utility meter of aspect 11, wherein the metrology processor is co-located with the one or more current and voltage sensors.
13. The utility meter of any preceding aspect, further comprising a display coupled to the application processor, wherein the application processor is configured to provide the energy consumption data to the display.
14. The utility meter of any preceding aspect, wherein the application processor is co-located with the display.
15. The utility meter of any preceding aspect, further comprising an analog front end coupled between the one or more sensors and the metrology processor, the analog front end configured to receive the input current and voltage measurements, convert the received analog signals to digital signals and provide the digital signals to the metrology processor.
16.The utility meter of any preceding aspect, further comprising a network interface controller coupled to the application processor, wherein the application processor is configured to provide the energy consumption data to the network interface controller.
17. The utility meter of aspect 11, wherein the one or more current sensors comprise a current shunt or a Rogowski coil.
18. The utility meter of any preceding aspect, wherein the application processor is further configured to store energy consumption readings locally in EEPROM.

A second set of non-limiting aspects of the disclosure are set out in the following numbered clauses.
1. A utility meter comprising:
   a metrology processor configured to receive input current and voltage measurements from one or more sensors and determine an energy consumption based on the measurements;
   an application processor configured to receive the energy consumption data from the metrology processor and output the energy consumption data;
   a primary communication link between the metrology processor and the application processor configured to transmit the energy consumption data from the metrology processor to the application processor;
   a secondary communication link between the metrology processor and the application processor configured to transmit the energy consumption data from the metrology processor to the application processor.
2. The utility meter according to aspect 1, wherein the secondary communication link is an optical communication link.
3. The utility meter according to aspect 2, wherein the optical communication link comprises a light source coupled to and controlled by the metrology processor and a photodetector coupled to the application processor, wherein the metrology processor is configured to transmit energy consumption data using the light source and the application processor is configured to determine the energy consumption based on one or more optical signals received at the photodetector from the light source.
4. The utility meter according to aspect 3, further comprising a filter coupled to the photodetector, wherein the filter is a narrowband band-pass filter with a pass-band centred on a frequency range in which the light source transmits light when indicating energy consumption.
5. The utility meter according to aspect 3 or aspect 4, further comprising a light pipe or optical channel between the light source and the photodetector, the light pipe or optical channel configured to provide internal optical transmission.
6. The utility meter according to any preceding aspect, wherein the secondary communication link operates using the same technology as the primary communication link.
7. The utility meter according to any of aspects 1-5, wherein the secondary communication link operates using a different technology to the primary communication link.
8. The utility meter according to any preceding aspect, wherein the secondary communication link is a pulse-based communication link, wherein the energy consumption data is encoded in a frequency or pulse-width of a signal transmitted over the secondary communication link.
9. The utility meter according to any preceding aspect, wherein the secondary communication link is unidirectional.
10. The utility meter according to any preceding aspect, wherein the primary communication link is a bidirectional communication link.
11. The utility meter according to any preceding aspect, wherein the primary communication link is a register-based communication link, wherein the application processor is configured to request energy consumption data from the metrology processor using the primary communication link and, in response to the request, the metrology processor is configured to transmit the energy consumption data from a register to the application processor using the primary communication link.
12. The utility meter according to any of aspects 1-9, wherein the primary communication link is a unidirectional communication link.
13. The utility meter according to any preceding aspect, wherein the primary communication link is a radio frequency communication link.
14. The utility meter according to any of aspects 1-12, wherein the primary communication link is an I2C, SPI or UART communication link.
15. The utility meter according to any preceding aspect, further comprising a third communication link between the metrology processor and the application processor, wherein the third communication link is configured to transmit the energy consumption data from the metrology processor to the application processor.
16. The utility meter according to any preceding aspect, wherein the application processor is configured to compare the energy consumption data received from the primary communication link and the secondary communication link.
17. The utility meter according to aspect 16, wherein if the energy consumption data received from the primary communication link and the secondary communication link are different, the application processor is configured to determine that there is a fault and output a fault notification.
18. The utility meter according to any preceding aspect, wherein if the application processor stops receiving energy consumption data from one of the primary communication link or the secondary communication link, the application processor is configured to determine that there is a fault and output a fault notification.
19. The utility meter according to aspect 17 or aspect 18, wherein if a fault is present, the application processor uses the primary communication link to interrogate one or more registers of the metrology processor that store energy consumption data.
20. The utility meter according to aspect 17 or aspect 18, wherein the fault notification is transmitted to one or more systems external to the application processor.
21. The utility meter according to any of aspects 17-20, wherein if a fault is present, the application processor may consider one or more CRC codes embedded within the energy consumption data.
22. The utility meter according to any preceding aspect, wherein the metrology processor and the application processor are physically separated and connected via the primary communication link and the secondary communication link.
22. The utility meter of any preceding aspect, further comprising one or more voltage sensors and current sensors coupled to the metrology processor and configured to provide the input current and voltage measurements.
23. The utility meter of aspect 22, wherein the metrology processor is co-located with the one or more voltage sensors and current sensors.
24. The utility meter of any preceding aspect, further comprising a display coupled to the application processor, wherein the application processor is configured to output the energy consumption data to the display.
25. The utility meter of aspect 24, wherein the application processor is co-located with the display.
26. The utility meter of any preceding aspect, further comprising an analog front end coupled between the one or more sensors and the metrology processor, the analog front end configured to receive input analog current and analog voltage measurements from the one or more sensors, convert the received analog signals to digital signals and provide the digital signals to the metrology processor.
27. The utility meter of aspect 26, further comprising a network interface controller coupled to the application processor, wherein the application processor is configured to provide the energy consumption data to the network interface controller.
28. The utility meter of any preceding aspect, wherein the one or more sensors comprise a current shunt or a Rogowski coil.
29. The utility meter of any preceding aspect, wherein the application processor is further configured to store energy consumption readings locally in EEPROM.
30. A method of controlling a utility meter comprising a metrology processor and an application processor, the method comprising:
   receiving input current and voltage measurements from one or more sensors at the metrology processor;
   determining, using the metrology processor, an energy consumption based on the measurements;
   transmitting energy consumption data from the metrology processor to the application processor using a primary communication link;
   transmitting the energy consumption data from the metrology processor to the application processor using a secondary communication link;
   outputting the energy consumption data using the application processor.
31. The method according to aspect 30, further comprising:
   comparing, using the application processor, the energy consumption data received from the primary communication link and the secondary communication link,
   wherein if the energy consumption data received from the primary communication link and the secondary communication link are different, the application processor determines that there is a fault and outputs a fault notification.
32. A utility meter comprising:
   a metrology processor configured to receive input current and voltage measurements from one or more sensors and determine an energy consumption based on the measurements;
   an application processor configured to receive the energy consumption data from the metrology processor;
   a primary communication link between the metrology processor and the application processor configured to transmit the energy consumption data between the processors;
   an optical communication link between the metrology processor and the application processor configured to transmit the energy consumption data between the processors.

## Claims

1. A utility meter comprising:
a metrology processor configured to receive input current and voltage measurements from one or more sensors and determine an energy consumption based on the measurements;
an application processor configured to receive the energy consumption data from the metrology processor and output the energy consumption data;
a primary communication link between the metrology processor and the application processor configured to transmit the energy consumption data from the metrology processor to the application processor;
a secondary communication link between the metrology processor and the application processor configured to transmit the energy consumption data from the metrology processor to the application processor.

2. The utility meter according to claim 1, wherein the secondary communication link is an optical communication link.

3. The utility meter according to claim 2, wherein the optical communication link comprises a light source coupled to and controlled by the metrology processor and a photodetector coupled to the application processor, wherein the metrology processor is configured to transmit energy consumption data using the light source and the application processor is configured to determine the energy consumption based on one or more optical signals received at the photodetector from the light source.

4. The utility meter according to any preceding claim, wherein the secondary communication link operates using the same technology as the primary communication link.

5. The utility meter according to any of claims 1-3, wherein the secondary communication link operates using a different technology to the primary communication link.

6. The utility meter according to any preceding claim, wherein the secondary communication link is a pulse-based communication link, wherein the energy consumption data is encoded in a frequency or pulse-width of a signal transmitted over the secondary communication link.

7. The utility meter according to any preceding claim, wherein the primary communication link is a bidirectional communication link.

8. The utility meter according to any preceding claim, wherein the primary communication link is a register-based communication link, wherein the application processor is configured to request energy consumption data from the metrology processor using the primary communication link and, in response to the request, the metrology processor is configured to transmit the energy consumption data from a register to the application processor using the primary communication link.

9. The utility meter according to any preceding claim, wherein the primary communication link is one of a radio frequency, I2C, SPI or UART communication link.

10. The utility meter according to any preceding claim, further comprising a third communication link between the metrology processor and the application processor, wherein the third communication link is configured to transmit the energy consumption data from the metrology processor to the application processor.

11. The utility meter according to any preceding claim, wherein the application processor is configured to compare the energy consumption data received from the primary communication link and the secondary communication link.

12. The utility meter according to claim 11, wherein if the energy consumption data received from the primary communication link and the secondary communication link are different, the application processor is configured to determine that there is a fault and output a fault notification.

13. The utility meter according to any preceding claim, wherein if the application processor stops receiving energy consumption data from one of the primary communication link or the secondary communication link, the application processor is configured to determine that there is a fault and output a fault notification.

14. The utility meter according to claim 12 or claim 13, wherein if a fault is present, the application processor uses the primary communication link to interrogate one or more registers of the metrology processor that store energy consumption data.

15. A method of controlling a utility meter comprising a metrology processor and an application processor, the method comprising:
receiving input current and voltage measurements from one or more sensors at the metrology processor;
determining, using the metrology processor, an energy consumption based on the measurements;
transmitting energy consumption data from the metrology processor to the application processor using a primary communication link;
transmitting the energy consumption data from the metrology processor to the application processor using a secondary communication link;
outputting the energy consumption data using the application processor.
